# EUROPEAN PATENT APPLICATION

(11) **EP 4 642 174 A1**
(43) Date of publication of application: **29.10.2025**
(21) Application number: 23905283.0
(22) Date of filing: 17.08.2023
(51) Int. Cl.: H05K 5/02, G02B 5/18

(54) **APPEARANCE DECORATION PART, METHOD FOR MANUFACTURING APPEARANCE DECORATION PART, AND ELECTRONIC DEVICE**

(30) Priority: 20.12.2022 CN 202211639020
(71) Applicant: BYD Company Limited, Shenzhen, Guangdong 518118 (CN)
(72) Inventor: LAI, Xiulin, Shenzhen, Guangdong 518118 (CN); ZHAO, Fei, Shenzhen, Guangdong 518118 (CN); LI, Mutian, Shenzhen, Guangdong 518118 (CN); GAO, Wenquan, Shenzhen, Guangdong 518118 (CN); ZHANG, Chao, Shenzhen, Guangdong 518118 (CN)
(74) Representative: Mathys & Squire
(86) International application number: PCT/CN2023/113566
(87) International publication number: WO 2024/131104

(57) **Abstract**

An appearance decoration part (100), a method for manufacturing the appearance decoration part (100), and an electronic device. The appearance decoration part (100) comprises a texture surface (101), and the texture surface (101) is divided into multiple partition units (110) arranged in multiple rows and columns; each partition unit (110) comprises a sub-texture (11); the included angle of the sub-texture (11) relative to a row direction (x) is defined as a texture included angle (α); the sub-textures (11) of the multiple partition units (110) satisfy the following condition: the texture included angles (α) of any two adjacent sub-textures (11) in the first row are different, and the texture included angles (α) of the multiple sub-textures (11) in each column form an arithmetic progression in a column direction (y).

## Description

### CROSS-REFERENCE TO RELATED APPLICATIONS

The present disclosure claims priority to Chinese Patent Application No. 202211639020.4 filed on December 20, 2022, titled "APPEARANCE DECORATION PART, METHOD FOR MANUFACTURING APPEARANCE DECORATION PART, AND ELECTRONIC DEVICE", which is incorporated herein by reference in its entirety.

### FIELD

The present disclosure relates to the field of appearance decorations, specifically to an appearance decorative member, a method for manufacturing the appearance decorative member and an electronic device.

### BACKGROUND

With the advancement of science and technology, electronic products such as smart phones and tablets play an increasingly important role in consumers' daily work and life, and their frequency of use is increasing. In addition to meeting the functional requirements of electronic products, the design of products has also become an important factor in consumers' purchasing choices. At present, the decoration of electronic products is usually achieved through a change of materials and colors, with a single and limited decorative effect and a lack of dynamic effects.

### SUMMARY

The purpose of the present disclosure is to provide an appearance decorative member, a method for manufacturing the appearance decorative member and an electronic device, so as to solve the problems that the current electronic products have a single decorative effect and lack of dynamic effect.

In order to achieve the purpose of the present disclosure, the present disclosure provides the following technical solutions:
according to a first aspect, an appearance decorative member is provided in the present disclosure, the appearance decorative member includes a texture surface, the texture surface being divided into multiple partition units arranged in multiple rows and columns; each of the partition units having a sub-texture respectively; an included angle of the sub-texture relative to the row direction is defined as a texture angle, and the sub-textures of the multiple partition units satisfy the following requirements: the texture angles of any two adjacent sub-textures in the first row are different, and the texture angles of the multiple sub-textures in each column form an arithmetic progression along the column direction.

In an embodiment, a difference between the texture angles of any two adjacent sub-textures in the first row is greater than or equal to 5 °.

In an embodiment, an absolute value of a common difference of the arithmetic progression formed by the texture angle of the multiple sub-textures in each column along the column direction is greater than 0 °, and less than or equal to 60 °.

In an embodiment, all the sub-textures in at least two columns form a column texture group along the column direction, and the texture angles of all the sub-textures in the column texture groups in the same column have multiple common differences along the column direction.

In an embodiment, all sub-textures in at least two columns form a row texture group along the row direction, and the texture angle of all sub-textures in the row texture groups in the same row has one or more common differences along the row direction.

In an embodiment, sub-textures of the multiple partition units are rotationally symmetrical.

In an embodiment, structures of at least part of the sub-textures of the multiple partition units are different; or, any two of the sub-textures of the multiple partition units have the same structure.

In an embodiment, the shape and size of the multiple partition units are the same; or, the shapes of the multiple partition units are the same, and the sizes of the multiple partition units are different.

In an embodiment, the sub-texture includes a linear structure protruding from the texture surface.

In an embodiment, a width of the linear structure in the normal direction of the extension path of the linear structure is from 1 µm to 200 µm, and a height of the linear structure in the direction perpendicular to the height of the texture surface is from 1 µm to 15 µm.

In an embodiment, a width of the linear structure in the normal direction of the extension path of the linear structure is from 10µm to 100 µm, and a height of the linear structure in the height direction perpendicular to the texture surface is from 3 µm to 8 µm.

In an embodiment, the cross-sectional shape of the linear structure is any one of an arc shape, a triangle shape, a trapezoid shape, and a saddle shape.

In an embodiment, each of the sub-textures has a chamfer.

According to a second aspect, a method for manufacturing an appearance decorative member is provided in the present disclosure, the method includes: a photolithographic master die having a sub-texture is manufactured; a PC mold or a GDM mold is manufactured by the photolithographic master die; the sub-texture is copied onto a PET explosion-proof film or a PC + PMMA composite board by the PC mold to form the appearance decorative member; or, the sub-texture is copied onto the glass by the GDM mold to form the appearance decorative member.

The photolithographic master die has multiple partition units, and each of the partition units has a sub-texture.

An included angle of the sub-texture relative to the row direction is defined as a texture angle, and the sub-textures of the multiple partition units satisfy the following requirements:
the texture angles of any two adjacent sub-textures in the first row are different, and the texture angles of the multiple sub-textures in each column form an arithmetic progression along the column direction.

According to a third aspect, an electronic device is further provided in the present disclosure, and the electronic device includes the appearance decorative member in any of the various embodiments of the first aspect.

In the appearance decorative member provided in the present disclosure, the texture surface is divided into multiple partition units arranged in multiple rows and columns, and each of the partition units has a sub-texture, which satisfies the condition that the texture angles of any two adjacent sub-textures in the first row are different, and the texture angles of the multiple sub-textures in each column form an arithmetic progression along the column direction, so that the multiple sub-textures form a regular arrangement, and when illuminated by an external light source, the manufactured object reflects light and presents a regular light and shadow effect, and at the same time, the light and shadow can be dynamically changed with the change of the relative position with the light source, thus realizing rich decorative effects and dynamic effects.

### BRIEF DESCRIPTION OF THE DRAWINGS

In order to more clearly explain the embodiments of the present disclosure or the technical solutions in the prior art, the drawings that need to be used in the description of the embodiments or the prior art will be briefly introduced below, and it is obvious that the drawings in the following description are only some embodiments of the present disclosure, and for a person skilled in the art, other drawings can be obtained from these drawings without making creative efforts.
FIG. 1 is a schematic diagram of texture partitioning according to an embodiment;
FIG. 2 is a schematic diagram of sub-textures of one row of multiple partition units according to an embodiment;
FIG. 3 is a schematic diagram of sub-textures of four columns of multiple partition units according to different embodiments;
FIG. 4 is a schematic diagram of sub-textures of one column of multiple partition units according to an embodiment;
FIG. 5 is a schematic diagram of sub-textures of multiple rows and columns of multiple partition units according to an embodiment;
FIGS. 6a to 6e are schematic diagrams of sub-textures according to some embodiments;
FIG. 7 is a schematic diagram of sub-textures of two rows and two columns of partition units according to an embodiment;
FIG. 8 is a schematic diagram of sub-textures of two rows and two columns of partition units according to another embodiment;
FIG. 9 is a schematic diagram of sub-textures of multiple rows and columns of multiple partition units according to an embodiment;
FIGS. 10a to 10e are schematic diagrams of sub-textures of multiple rows and columns of multiple partition units according to some embodiments;
FIG. 11 is a texture rendering diagram of a back cover of a mobile phone according to an embodiment.

Description of the main symbols of the drawings: 100-Appearance decorative member, 101-Texture surface, 11-sub-texture, 110-partition unit, 111-column texture group, 111a-first column texture, 111b-second column texture, 112-row texture group, 112a-first row texture, 112b-second row texture, 10-substrate, 20-linear structure, α-texture angle.

### DETAILED DESCRIPTION

Hereinafter, the technical solutions in the embodiments of the present disclosure will be clearly and completely described with reference to the drawings in the embodiments of the present disclosure, and it is obvious that the described embodiments are only a part of the embodiments of the present disclosure, but not all the embodiments. According to the embodiments in the present disclosure, all other embodiments obtained by a person skilled in the art without creative work fall within the scope of protection of the present disclosure.

It will be noted that when a component is referred to as "fixed" to another component, it may be directly on the other component or an intermediate component may also be present. When one component is considered to be "connected" to another component, it can be directly connected to the other component or there may be an intermediate component at the same time.

Unless otherwise defined, all technical and scientific terms used herein have the same meanings as commonly understood by a person skilled in the art belonging to this disclosure. The terminology used in the specification herein is for the purpose of describing specific embodiments only, and is not intended to limit the present disclosure. As used herein, the term "and/or" includes any and all combinations of one or more related listed items.

Some embodiments of the present disclosure will be described in detail below with reference to the accompanying drawings. The following embodiments and features in the embodiments may be combined with each other without conflict.

An appearance decorative member is provided in an embodiment of the present disclosure, the appearance decorative member includes a texture surface and a non-texture surface, the texture surface is formed with a specific texture, and the non-texture surface has no texture or has texture but the texture is non-specific. It is an object of the present disclosure to provide a specific texture of a texture surface. It will be appreciated that a texture surface is typically a surface that can be viewed from the outside, and a non-texture surface may be a hidden unobservable surface. The appearance decorative member can be manufactured by steps including the texture partitioning and texture manufacturing. The appearance decorative member can be a case of a mobile phone, a back cover of a mobile phone, a film of a mobile phone, and any other feasible products without limitation.

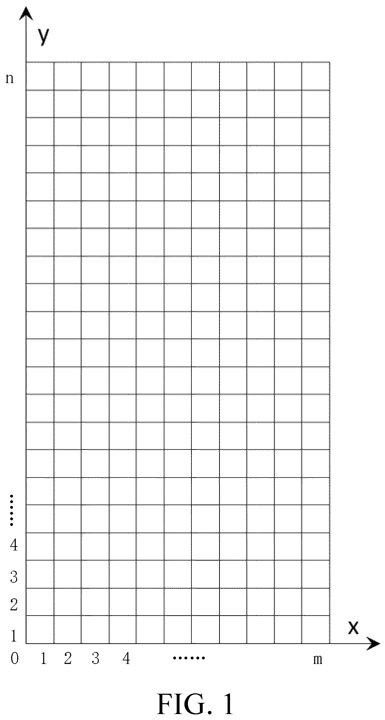

Referring to FIG. 1, in the step of texture partitioning, the texture surface is divided into multiple partition units arranged in multiple rows and columns, so that the texture surface is divided into multiple regularly arranged partition units arranged in multiple rows and columns by texture partitioning.

Specifically, the appearance decorative member can be a PC (polycarbonate) explosion-proof film, a PC + PMMA (polymethyl methacrylate) composite board, glass, etc. Depending on the different appearance decorative members, the texture surface can be the surface of PC explosion-proof film, the surface of PC + PMMA composite board, the surface of glass, etc., without limitation.

A texture surface can be flat or curved without limitation. When the texture surface is a curved surface, the texture partitioning can be performed on the plane and then projected onto the texture surface to form the texture partitioning on the curved surface.

When performing the texture partitioning, an x-y coordinate system can be established, with the x direction as the row direction and the y direction as the column direction. Multiple straight lines at intervals are drawn along the row direction and the column direction respectively, taking the zero point of the x-y coordinate system as the reference, and multiple straight lines in the row direction and multiple straight lines in the column direction intersect and jointly enclose to form multiple partition units arranged in multiple rows and columns, and each of the partition units is rectangular. When separation distances of multiple straight lines in the row direction and in the column direction are equal, the partition unit formed is square. For convenience of description, in the direction from bottom to top, from left to right, multiple partition units include m × n partition units of x1y1, x2y1, x1y2, ..., xmyn, in total m columns and n rows, wherein m and n are positive integers greater than 2.

In an embodiment, multiple partition units may be formed by drawing a non-straight line in the x-y coordinate system so that the partition units are non-rectangular, for example, the partition units may be circular, triangular, hexagonal, etc. without limitation.

In an embodiment, the row direction and the column direction may be interchanged. As shown in FIG. 1, if the viewing angle is rotated by 90 °, the row direction may be the y direction and the column direction may be the x direction.

The size of the partition unit can be set as needed. In an embodiment, the side length (diameter) of the partition unit is 0.01 mm to 1 mm, and specifically 0.01 mm, 0.05 mm, 0.1 mm, 0.2 mm, 0.3 mm, 0.4 mm, 0.5 mm, 0.6 mm, 0.7 mm, 0.8 mm, 0.9 mm, 1 mm, etc., without limitation. In order to improve texture fineness and reduce graininess, the side length (diameter) of the partition unit may be 0.01 mm to 0.1 mm, specifically 0.01 mm, 0.02 mm, 0.03 mm, 0.04 mm, 0.05 mm, 0.06 mm, 0.07 mm, 0.08 mm, 0.09 mm, 0.1 mm, etc., without limitation. The shape of the partition unit of the embodiment shown in FIG. 1 is square, and the side length is 0.05 mm.

It can be understood that the size of the partition unit is related to the size of the sub-textures formed in the partition unit, and the size and density of distribution of the sub-textures determine the roughness or delicacy of the visual perception. Generally speaking, the denser the partition unit and the smaller the size, the finer the formed visual texture appears, and vice versa. From the perspective of production cost, the denser the texture and the smaller the size, the greater the production difficulty and the higher the cost. Therefore, the appropriate size of partition unit should be selected to the balance direction of visual aesthetics and production cost.

In an embodiment, the step of texture partitioning may be performed in an electronic computer by a computer program, and the data of the texture surface can be entered in the computer program, so that the data in the computer program can correspond to the texture surface of the real object when the step of manufacturing the texture surface is subsequently performed. The use of electronic computers can improve work efficiency. In an embodiment, the step of texture partitioning can also be performed directly on the surface of the object (i.e., the texture surface).

After performing the step of texture partitioning, the required textures can be respectively manufactured in the obtained partition units of multiple rows and multiple columns, and through the texture partitioning, the texture of each of the partition units can be designed, so that the whole texture of multiple partition units presents unique light and shadow effects.

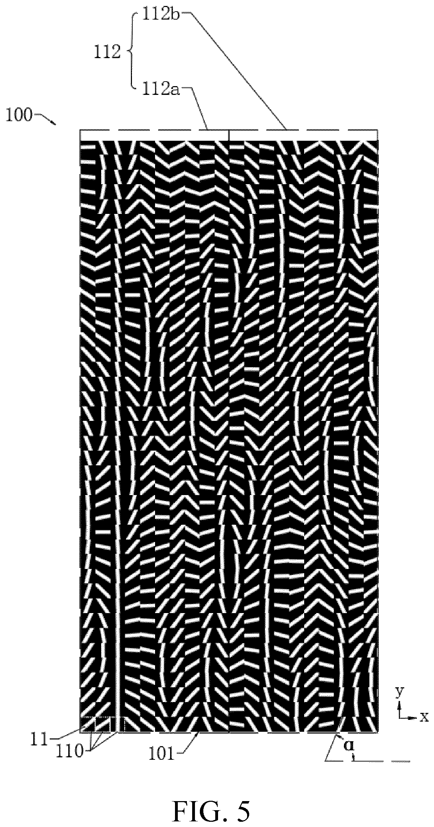

Referring to FIG. 5, the appearance decorative member 100 includes a texture surface 101. The texture surface 101 is divided into multiple partition units 110 arranged in multiple rows and columns. Each of the partition units 110 has a sub-texture 11, respectively. In the step of manufacturing the texture surface 101, the sub-texture 11 is respectively manufactured in each of the partition units 110 so that each of the partition units 110 has the sub-texture 11 respectively. In the figure of FIG. 5, partition units 110 and sub-textures 11 are shown in white letters on a black background, the partition unit 110 is shown on a black background, and the sub-texture 11 is shown in white strips. The partition units 110 and sub-textures 11 of similar patterns in other drawings are the same as those of FIG. 5, and will not be described later.

In an embodiment, the sub-textures 11 are formed in each of the multiple partition units 110, and each of the partition units 110 has at least one sub-texture 11. As shown in FIG. 5, one sub-texture 11 is arranged in each of the partition units 110. In other embodiments, two or more sub-textures may be arranged in each of the partition units.

During the manufacturing process, sub-textures 11 can be simultaneously manufactured in all partition units 110, or sub-textures 11 can be manufactured one by one in multiple partition units 110, or sub-textures 11 can be synchronously manufactured in rows or columns without limitation. In an embodiment of the present disclosure, the specific shape and manufacturing process of the sub-texture 11 are not limited. Specifically, the sub-texture 11 can be a straight line type, a folded line type, an arc line type, or the like.

In the step of texture manufacturing, the included angle of the sub-textures 11 relative to the row direction (referring to the x direction in FIG. 1, the horizontal direction shown in FIG. 5, that is, the widthwise direction) is defined as a texture angle α, and the sub-textures 11 of the multiple partition units 110 satisfy the following conditions 1 and 2.

Condition 1: texture angles α of any two adjacent sub-textures 11 in the first row are different.

Condition 2: texture angles α of multiple sub-textures 11 in each column form an arithmetic progression along the column direction y.

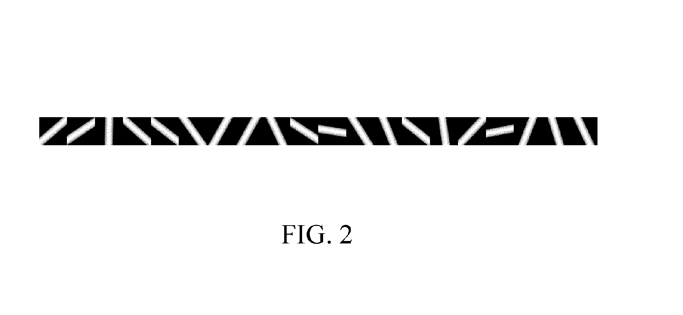

Referring to FIGS. 1, 2, and 5, the figure in FIG. 2 is a figure of m partition units 110 in the first row from the bottom, from the bottom to the top in FIG. 5.

Referring to FIGS. 2 and 5, the sub-textures 11 in the multiple partition units 110 in the first row from the bottom of FIG. 5 satisfy the aforementioned condition 1, that is, the texture angles α of any two adjacent sub-textures 11 of the sub-textures 11 in the m partition units 110 in the first row are different.

It can be understood that the sub-texture 11 itself has a shape, and the texture angle α is an included angle between the overall extending direction of the sub-texture 11 and the row direction. For example, when the sub-texture 11 has a straight line shape, the texture angle α is the included angle between the straight line and the row direction; and when the sub-texture 11 has a non-straight line type such as a folded line type or an arc line type, the texture angle α may be an included angle between a line connecting two end points of the non-straight line such as a folded line or an arc line and the row direction.

In an embodiment, referring to FIGS. 1 and 5, the first row of the multiple partition units may be the first row form the bottom or the first row from the top, and is not limited.

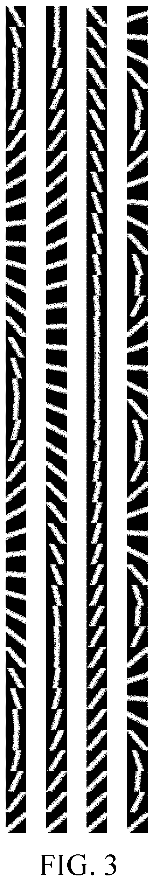

Referring to FIG. 3, FIG. 3 shows images of sub-textures of partition units in the column direction of the four embodiments, where condition 2 is satisfied, that is, texture angles of multiple sub-textures of each column form an arithmetic progression along the column direction.

Specifically, as shown in FIG. 3, the structures of partition units and sub-textures therein in four columns of different embodiments are shown from left to right, and in the four embodiments, from bottom to top, the texture angle of the sub-textures in the first row from the bottom is the same, which is 45 °. From left to right, the common difference of the arithmetic progression of the texture angles of the multiple sub-textures in the first column is 22.5 °, the common difference of the arithmetic progression of the texture angles of the multiple sub-textures in the second column is 11.25 °, the common difference of the arithmetic progression of the texture angles of the multiple sub-textures in the third column is 2 °, and the common difference of the arithmetic progression of the texture angles of the multiple sub-textures in the fourth column is 45 °. That is to say, for the sub-textures with the same texture angle in the first row, after rotating and arranging with different common differences of arithmetic progression, the overall texture structures of each column obtained are different.

It can be seen that the shapes of the whole column obtained are different by performing arithmetic progression with different common differences on sub-textures with the same texture angle. In addition, referring to FIG. 5, on the one hand, texture angles α of each sub-texture 11 in the first row from the bottom are different, and at the same time, the arithmetic progression is performed with different common differences for each column, and the obtained shape has a specific regularity, and any row is not completely the same as the other rows, and any column is not completely the same as the other columns, so that a specific texture pattern is formed.

After the texture is formed on the texture surface of the appearance decorative member, each of the sub-textures forms a reflective grating. Since the multiple sub-textures satisfy the aforementioned condition 1 and condition 2, the whole of the multiple sub-textures forms a regular arrangement, and when illuminated by an external light source, the manufactured object reflects light and presents a regular light and shadow effect, and the visual effect is rich, and at the same time, the light and shadow can be dynamically changed with a change of the relative position with the light source, so as to realize the dynamic effect.

Therefore, in the appearance decorative member provided in the embodiment of the present disclosure, the texture surface is divided into multiple partition units arranged in multiple rows and columns, and each of the partition units has a sub-texture, which satisfies the condition that the texture angles of any two adjacent sub-textures in the first row are different, and the texture angles of the multiple sub-textures in each column form an arithmetic progression along the column direction, so that the multiple sub-textures form a regular arrangement, and when illuminated by an external light source, the manufactured object reflects light and presents a regular light and shadow effect, and at the same time, the light and shadow can be dynamically changed with a change of the relative position with the light source, and the appearance decorative member provided in the embodiment of the present disclosure can realize rich decorative effects and dynamic effects.

In an embodiment, the difference between the texture angles of any two adjacent sub-textures in the first row is greater than or equal to 5 °, and specifically, the difference may be 5 °, 8 °, 10 °, 15 °, 20 °, etc., without limitation. Combining FIG. 1 and FIG. 2, m partition units are arranged in the first row, each of the partition units has a sub-texture, and each of the sub-textures has a texture angle with the row direction (i.e., the x-direction). The sub-textures in the first row are configured as the reference of other sub-textures, and the difference of the texture angles of any two adjacent sub-textures in the first row is greater than or equal to 5 °, so that after the angle change of the arithmetic progression, the angle difference of the texture angle of the sub-textures between the adjacent columns is not too small, resulting in little change of the visual effect, and obviously different visual effect differences can be obtained, so as to realize the required decorative effects and dynamic effects.

The common differences of the arithmetic progression of the multiple columns of sub-textures may be equal or unequal. When the common differences of the arithmetic progression of the multiple columns of sub-textures are not equal, in some rows (other than the first row) after the arithmetic progression arrangement, the texture angles of two adjacent sub-textures can be equal, that is, the difference of texture angles is 0. It is also possible that in some rows (other than the first row), the angle between two adjacent sub-textures is less than 5 °, without limitation.

In an embodiment, the common differences of the arithmetic progression formed by the texture angle of the multiple sub-textures in each column along the column direction may be a positive number or a negative number, and the absolute value of the common difference may be greater than 0 ° and less than or equal to 60 °, and the absolute value of the common difference may be 1 °, 5 °, 10 °, 15 °, 30 °, 45 °, 60 °, etc., without limitation. The absolute value of the common difference is set within the range, so that the texture angles of any two adjacent sub-textures in the same column do not change too much, the transition will not be too abrupt on the whole, and the visual effect is good.

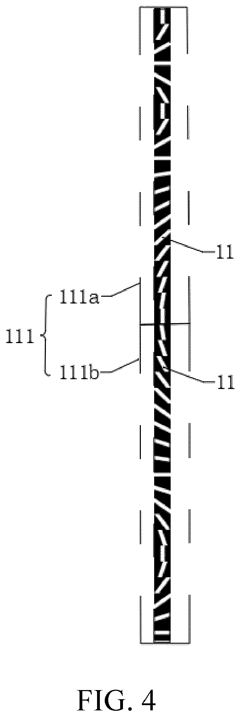

In an embodiment, all the sub-textures 11 in at least two columns form a column texture group 111 along the column direction, and the texture angles of all the sub-textures 11 in column texture groups 111 in the same column have multiple common differences along the column direction. Referring to FIG. 4, along the column direction, the column texture group 111 includes a first column texture 111a and a second column texture 111b. Specifically, in column texture groups 111 in the same column, the texture angles of the multiple sub-textures 11 (for example, the first column texture 111a) from the first row (the first row from the bottom) to a certain row in the middle may be arranged at a common difference of 18 °; and the texture angles of the multiple sub-textures 11 from a certain row in the middle to a certain row in the upper (which may be the last row, i.e. the first row from the top, for example the second column of texture 111 b) are arranged at another common difference of -10 °. That is, the texture angles of all sub-textures 11 in column texture groups 111 in the same column may be arranged at one common difference first, and then at other common differences.

In an embodiment, all sub-textures 11 in at least two columns form a row texture group 112 along the row direction, and the texture angle α of all sub-textures 11 in row texture groups in the same row has one or more common differences along the row direction. Referring to FIG. 5, exemplarily, in the embodiment, the row texture group 112 includes a first row texture 112a and a second row texture 112b along the row direction. Specifically, in row texture groups 112 in the same row, the texture angle α of the multiple sub-textures 11 (for example, the first row texture 112a) from the first column (the first column from the left) to a certain column in the middle may be arranged at a first common difference; and the texture angle α of the multiple sub-textures 11 from a certain column in the middle to a certain column close to the right (which may be the last column, i.e. the first column from the right, for example the second row texture 112b) is arranged at another second first common difference, wherein the first common difference is different from the second common difference. In some embodiments, the first common difference is the same as the second common difference. That is, the texture angle α of all sub-textures 11 in row texture groups 112 in the same row may be arranged at one common difference first, and then arranged at other common differences.

It is understood that the texture angles of all sub-textures 11 in column texture groups 111 in the same column may have two or more common differences. The texture angles of all sub-textures 11 in row texture groups 112 in the same row may have two or more common differences.

Different form the embodiment shown in FIG. 4, in the four embodiments shown in FIG. 3, the common differences of the texture angles of all the sub-textures in one column are the same.

This arrangement can provide richer changes in texture angles, and enrich decorative effects and dynamic effects.

In an embodiment, referring to FIG. 5, sub-textures 11 of the multiple partition units 110 are rotationally symmetrical. Specifically, since the shapes, sizes, and the like of the sub-textures 11 in the multiple partition units 110 are the same, and the only difference is that texture angles α are different, when the sub-textures 11 are rotated so that the texture angles α are the same, the sub-textures 11 can completely overlap each other, and thus the sub-textures 11 are rotationally symmetrical. This arrangement makes the multiple sub-textures 11 simple in shape and easy to manufacture.

It will be understood that the sub-textures 11 in all of the partition units 110 may be rotationally symmetrical; the sub-textures 11 in some partition units 110 may be rotationally symmetrical, and the sub-textures 11 in other partition units 110 may not be rotationally symmetrical.

In an embodiment, the multiple partition units 110 may have the same shape but different sizes, and the sub-textures 11 may only be partially overlapped rather than completely overlapped after rotating.

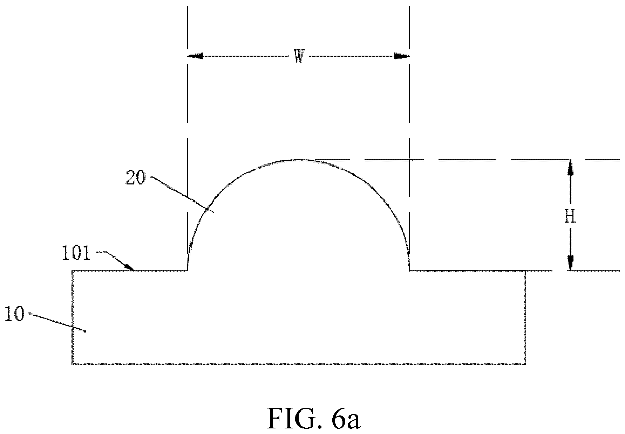

In an embodiment, referring to FIGS. 5 and 6a to 6e, sub-textures are respectively manufactured in each of the partition units 110, which includes:

a linear structure 20 is manufactured in the partition unit 110, and the linear structure protrudes from the texture surface 101 to form a sub-texture 11, and the linear structure 20 extends along a straight line. That is, the sub-texture 11 is a linear structure 20 extending along a straight line. The size of the linear structure 20 may be micron or even nanometer, and the size is so small that a single sub-texture 11 cannot be distinguished by the naked eye, and the combination of multiple sub-textures 11 can form a rich visual effect.

Specifically, as shown in a side view (which may also be a cross-sectional view) of a sub-texture in one of the partition units of FIGS. 6a to 6e, the linear structure 20 of the sub-texture is formed on a substrate 10. The substrate 10 is an appearance decorative member, for example, a PC explosion-proof film, a PC + PMMA composite board, glass, or the like, without limitation. The material of the linear structure 20 is the same as that of the substrate 10, and the linear structure 20 and the substrate 10 may be an integrated structure in which the linear structure 20 and the substrate 10 are integrally molded, or the substrate 10 may be prepared first, and then the linear structure 20 may be formed on the substrate 10 by means of embossing, machining, or the like.

The linear structure 20 extends along a straight line, which can form a better reflective grating, and realize rich decorative effects and dynamic effects.

It will be understood that a large number of linear structures 20 can be formed on one substrate 10, and each of the linear structures 20 is one sub-texture, and then an appearance decorative member with a required size can be obtained by cutting the substrate 10, and the appearance decorative member can be used as a case of a mobile phone, a film of a mobile phone, a back cover of a mobile phone, etc.

In an embodiment, referring to FIG. 6a, the width W of the linear structure 20 in the normal direction of the extension path of the linear structure 20 is from 1 µm to 200 µm, and the height H of the linear structure 20 in the direction perpendicular to the height of the texture surface 101 is from 1 µm to 15 µm. Preferably, the width W of the linear structure 20 in the normal direction of the extension path of the linear structure 20 is from 10 µm to 100 µm, and the height H of the linear structure 20 in the height direction perpendicular to the texture surface 101 is from 3 µm to 8 µm. It will be noted that the term "width direction of the linear structure 20" refers to the normal direction of the linear structure 20 along the extension path of the linear structure 20, and the normal direction of the extension path is perpendicular to the tangential direction of the extension path.

According to the processing accuracy that can be achieved at present, the size of the linear structure 20 is made as small as possible on the basis of considering the cost, so that the overall texture formed is finer and the graininess is weaker. Within the above-described size range, the linear structure 20 is easy to manufacture, has low cost, has good fineness of texture, and has weak graininess.

Referring to FIGS. 6a to 6e, the cross-sectional shape of the linear structure 20 is any one of an arc shape, a triangle shape, a trapezoid shape, and a saddle shape.

Specifically, FIG. 6a shows an embodiment in which the cross-sectional shape of the linear structure 20 is an arc shape, and the arc shape may be a semicircle or an arc of other radians without limitation.

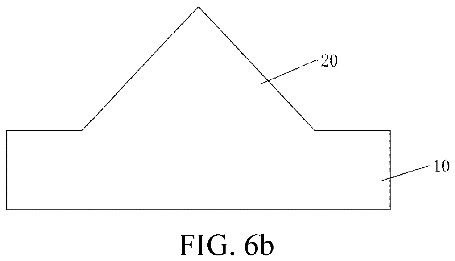

FIG. 6b shows an embodiment in which the cross-sectional shape of the linear structure 20 is an isosceles triangle shape.

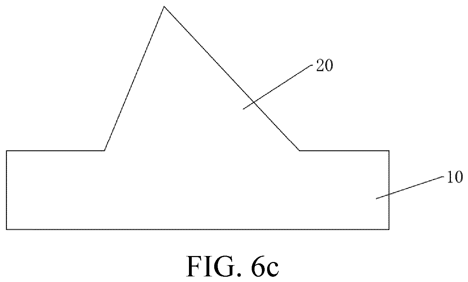

FIG. 6c shows an embodiment in which the cross-sectional shape of the linear structure 20 is a general triangular shape.

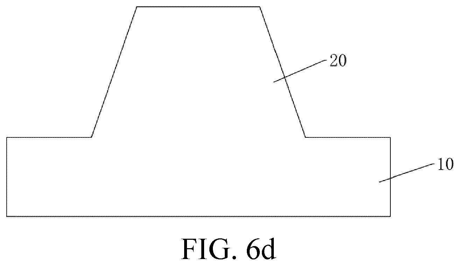

FIG. 6d shows an embodiment in which the cross-sectional shape of the linear structure 20 is an isosceles trapezoid shape, and in other embodiments, the cross-sectional shape of the linear structure 20 may also be a general trapezoid shape.

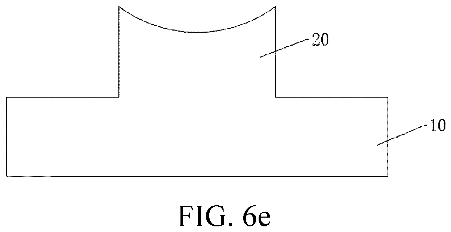

FIG. 6e shows an embodiment in which the cross-sectional shape of the linear structure 20 is a saddle shape.

It will be understood that the cross-sectional shape of the linear structure 20 may also be any other possible shape without limitation.

In other embodiments, multiple linear structures 20 may be arranged in one partition unit, but not limited to one. The multiple linear structures 20 may be arranged in parallel with each other or may be arranged at least partially intersecting each other. Each of the linear structures 20 may have any shape and structure of the above-described 6a to 6c without limitation.

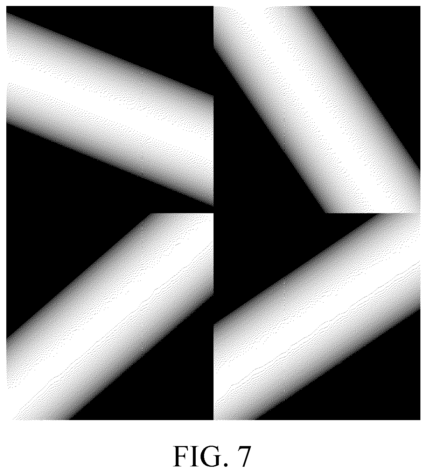

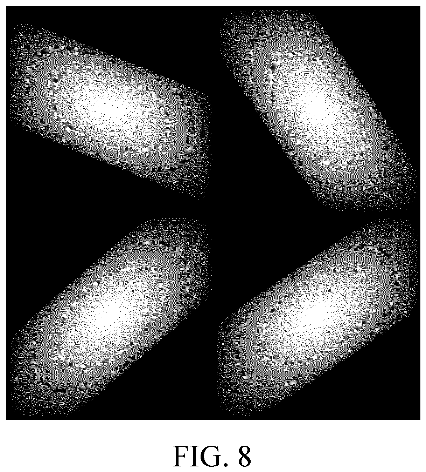

Referring to FIG. 7 and FIG. 8, each of the sub-textures has a chamfer.

As shown in FIG. 7, without chamfering, the corner contours of the sub-texture are sharp, which will interfere with each other at the intersection of two adjacent partition units, resulting in white spots and Moiré defects.

As shown in FIG. 8, after chamfering the sub-texture of FIG. 7, the corner contours of the sub-texture are soft, which will almost not interfere with each other at the intersection of two adjacent partition units, resulting in almost no white spots and Moiré defects.

It will be understood that chamfering refers to angular cutting of edges, corners, or the like of a shape to form a bevel or arc surface. The specific process of chamfering can be in any feasible manner without limitation.

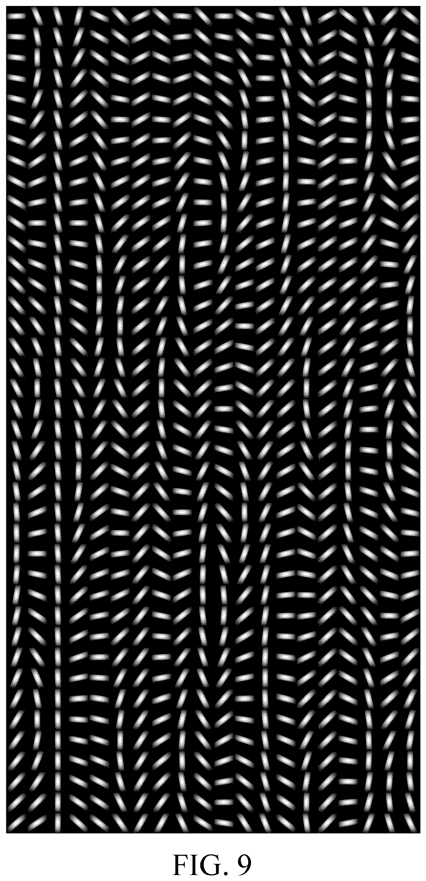

Referring to FIGS. 5 and 9, the un-chamfered texture in FIG. 5 has sharp edges and corners and has a poor visual effect, while the chamfered texture in FIG. 9 has no edges and corners and has a good visual effect.

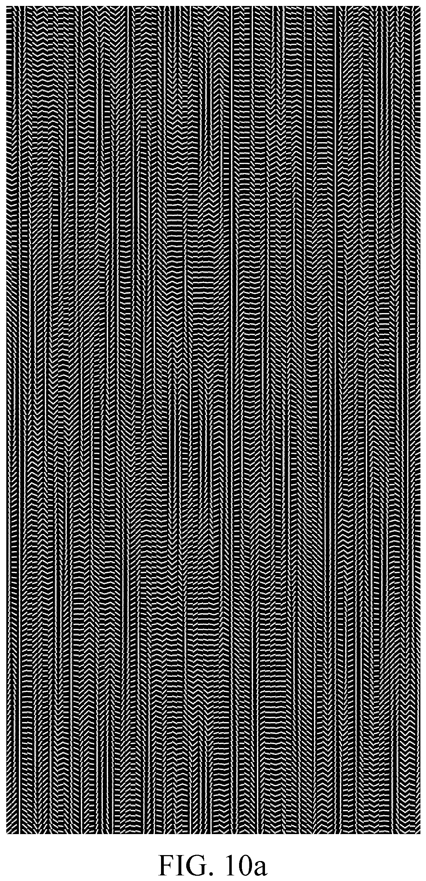

The appearance decorative member in the embodiment of the present disclosure can achieve various decorative effects. FIGS. 10a to 10e show some embodiments of the appearance decorative member such that the texture presents a viewing angle effect of the flow direction of the meteor light and shadow.

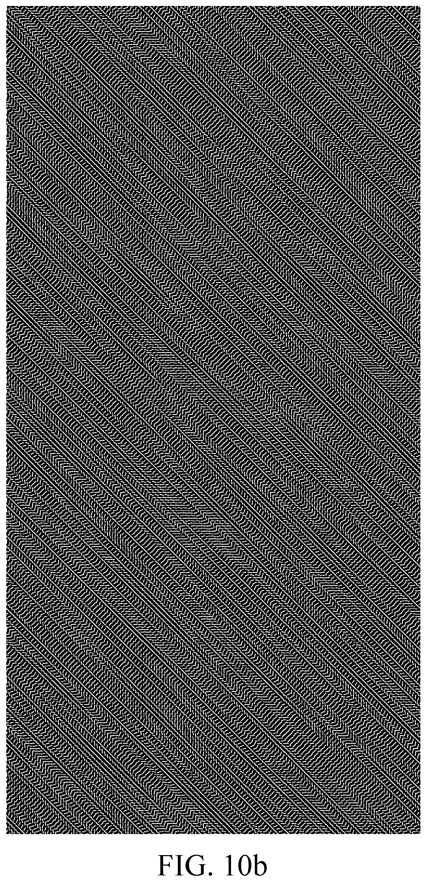

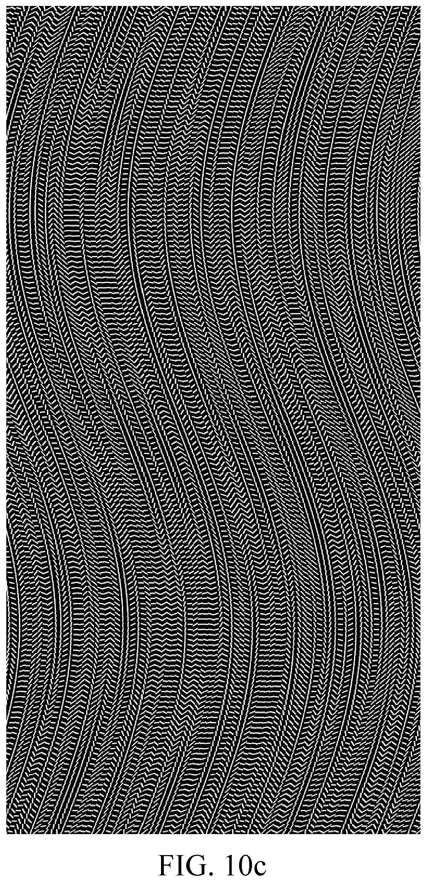

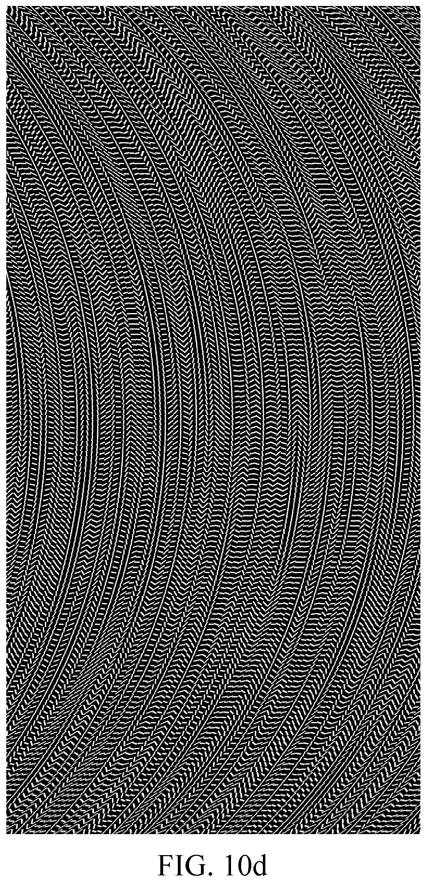

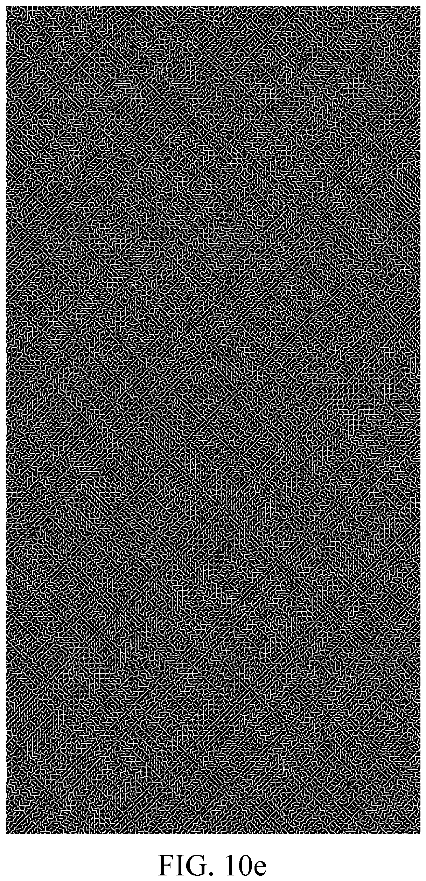

Specifically, referring to FIG. 10a, the texture presents a meteor light and shadow effect flowing in the vertical direction; in FIG. 10b, the texture presents a meteor light and shadow effect flowing in the direction of oblique lines; in FIG. 10c, the texture presents a meteor light and shadow effect flowing in S-line; in FIG. 10d, the texture presents a meteor light and shadow effect flowing in arc-line; and in FIG. 10e, the texture a meteor light and shadow effect flowing a cross-line.

It will be understood that the effect of texture presentation can be designed as desired without limitation.

A method for manufacturing an appearance decorative member is also provided in an embodiment of the present disclosure, the method includes:
a photolithographic master die having a sub-texture is manufactured;
PC (polycarbonate) molds or GDM (Glass Direct Molding, decorative process processing directly on glass) molds are manufactured by the photolithographic master die;
the sub-texture is copied onto a PET (polyethylene terephthalate) explosion-proof film or a PC + PMMA (polymethyl methacrylate) composite board by the PC mold to form an appearance decorative member;
or, the sub-texture is copied onto the glass by the GDM mold to form an appearance decorative member.

The photolithographic master die has multiple partition units, and each of the partition units has a sub-texture.

The included angle of the sub-texture relative to the row direction is defined as the texture angle, and the sub-textures of the multiple partition units satisfy the following requirements:
texture angles of any two adjacent sub-textures in the first row are different, and the texture angles of the multiple sub-textures in each column form an arithmetic progression along the column direction. By the above-described manufacturing method, it is possible to form an appearance decorative member satisfying the above-described embodiment, thereby providing a rich decorative effect and a dynamic effect.

The following provides some embodiments of specific manufacturing processes for manufacturing a back cover of a mobile phone, and in the embodiments the appearance decorative member is a back cover of a mobile phone.

In embodiment 1, a texture is designed, and then a photolithographic master die is manufactured by gray exposure, development and other processes, and then a PC mold is manufactured by anti-adhesive and UV glue transfer processes, and then the texture is copied onto a PET explosion-proof film by UV (photopolymer exposure) transfer process to form a texture film. The texture film is pasted on the glass shell or transparent injection PC shell through coating, silk screen printing bottom cover, laser cutting, lamination and other processes to form a back cover of a mobile phone.

In embodiment 2, a texture is designed, and then a photolithographic master die is manufactured by gray exposure, development and other processes, and then a PC mold is manufactured by anti-adhesive, UV glue transfer and other processes, and the characteristic structure is copied to a PC + PMMA composite board by UV transfer process. The composite board is performed by coating, silk screen printing bottom cover, high hot press molding, CNC (numerical control machine tool processing) and other processes to form a back cover of a mobile phone.

In embodiment 3, a texture is designed, and then a photolithographic master die is manufactured by gray exposure, development and other processes, and then a GDM mold is manufactured by anti-adhesive, UV glue transfer and other processes, and the characteristic structure is directly copied onto the glass by the GDM transfer process to form a back cover of a mobile phone. Among them, the GDM process refers to the process of directly decorating texture and color on the glass cover plate, and the GDM mold is used for the GDM process.

In embodiment 1 to embodiment 3, the specific content of each step is not limited, and any feasible solution in the related art can be used, and any other feasible steps can be included, and all of them are not limited.

It will be understood that a back cover of a mobile phone having a texture can also be manufactured by other processes, and is not limited to embodiments 1 to 3. At the same time, the appearance decorative member of the embodiment of the present disclosure may also be other products, and is not limited to the back cover of a mobile phone.

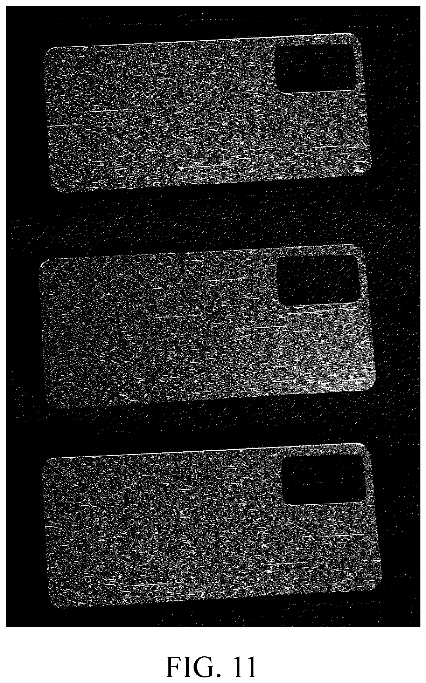

FIG. 11 shows a decorative effect of a back cover of a mobile phone under a point light source. When the back cover of the mobile phone and the point light source are at different relative positions, the texture on the back cover of the mobile phone changes, which has rich light and shadow effects and dynamic effects.

An electronic device is further provided in an embodiment of the present disclosure, and the electronic device includes the appearance decorative member in the aforementioned embodiment. The electronic device may be a smartphone, a tablet computer, or the like without limitation.

In the electronic device provided in the embodiment of the present disclosure, by adopting the appearance decorative member of the embodiment of the present disclosure, in the appearance decorative member a texture surface is divided into multiple partition units arranged in multiple rows and columns, and each of the partition units has a sub-texture, which satisfies the condition that the texture angles of any two adjacent sub-textures in the first row are different, and the texture angles of the multiple sub-textures in each column form an arithmetic progression along the column direction, so that the multiple sub-textures form a regular arrangement, and when illuminated by an external light source, the manufactured obj ect reflects light and presents a regular light and shadow effect, and at the same time, the light and shadow can be dynamically changed with the change of the relative position with the light source, thus realizing rich decorative effects and dynamic effects.

In the description of the embodiments of the present disclosure, it will be noted that the orientation or positional relationship of indicators such as "center", "upper", "lower", "left", "right", "vertical", "horizontal", "inner", and "outer" is based on the orientation or positional relationship described in the drawings, and is only for the convenience and simplification of the description of the present disclosure, and does not indicate or imply that the referred device or original must have a specific orientation, be constructed and operated in a specific orientation, and therefore cannot be understood as a limitation of the present disclosure.

The above disclosure is only one preferred embodiment of the present disclosure, and of course, it is not necessary to limit the scope of the present disclosure. A person skilled in the art can understand that all or part of the process of implementing the above embodiments and make equivalent changes according to the claims of the present disclosure still belong to the scope of the present disclosure.

## Claims

1. An appearance decorative member (100), the appearance decorative member (100) comprising a texture surface (101), and the texture surface (101) being divided into multiple partition units (110) arranged in multiple rows and columns; and each of the partition units (110) having a sub-texture (11) respectively;
an included angle of the sub-texture (11) relative to the row direction (x) being defined as a texture angle (α), and the sub-textures (11) of the multiple partition units (110) satisfying the following requirements:
the texture angles (α) of any two adjacent sub-textures (11) in the first row being different, and the texture angles (α) of the multiple sub-textures (11) in each column forming an arithmetic progression along the column direction (y).

2. The appearance decorative member (100) according to claim 1, wherein a difference between the texture angles (α) of any two adjacent sub-textures (11) in the first row is greater than or equal to 5 °.

3. The appearance decorative member (100) according to claim 1, wherein an absolute value of a common difference of the arithmetic progression formed by the texture angle (α) of the multiple sub-textures (11) in each column along the column direction (y) is greater than 0 °, and less than or equal to 60 °.

4. The appearance decorative member (100) according to claim 3, wherein all the sub-textures (11) in at least two columns form a column texture group (111) along the column direction (y), and the texture angles (α) of all the sub-textures (11) in the column texture groups (111) in the same column have multiple common differences along the column direction (y).

5. The appearance decorative member (100) according to claim 4, wherein all sub-textures (11) in at least two columns form a row texture group (112) along the row direction (X), and the texture angle (α) of all sub-textures (11) in the row texture groups (112) in the same row has one or more common differences along the row direction (X).

6. The appearance decorative member (100) according to claim 1, wherein sub-textures (11) of the multiple partition units (110) are rotationally symmetrical.

7. The appearance decorative member (100) according to claim 1, wherein structures of at least part of the sub-textures (11) of the multiple partition units (110) are different; or, any two of the sub-textures (11) of the multiple partition units (110) have the same structure.

8. The appearance decorative member (100) according to claim 1, wherein shapes and sizes of the multiple partition units (110) are the same; or, shapes of the multiple partition units (110) are the same, and sizes of the multiple partition units (110) are different.

9. The appearance decorative member (100) according to any one of claims 1 to 8, wherein the sub-texture (11) comprises a linear structure (20) protruding from the texture surface (101).

10. The appearance decorative member (100) according to claim 9, wherein a width of the linear structure (20) in the normal direction of the extension path of the linear structure (20) is from 1 µm to 200 µm, and a height of the linear structure (20) in the direction perpendicular to the height of the texture surface (101) is from 1 µm to 15 µm.

11. The appearance decorative member (100) according to claim 10, wherein a width of the linear structure (20) in the normal direction of the extension path of the linear structure (20) is from 10 µm to 100 µm, and a height of the linear structure (20) in the height direction perpendicular to the texture surface (101) is from 3 µm to 8 µm.

12. The appearance decorative member (100) according to claim 9, wherein a cross-sectional shape of the linear structure (20) is any one of an arc shape, a triangle shape, a trapezoid shape, and a saddle shape.

13. The appearance decorative member (100) according to any one of claims 1 to 8, wherein each of the sub-textures has a chamfer.

14. A method for manufacturing an appearance decorative member (100), comprising:
manufacturing a photolithographic master die having a sub-texture (11);
manufacturing a PC mold or a GDM mold by the photolithographic master die;
copying the sub-texture (11) onto a PET explosion-proof film or a PC + PMMA composite board by the PC mold to form the appearance decorative member (100);
or, copying the sub-texture (11) onto the glass by the GDM mold to form the appearance decorative member (100);
the photolithographic master die having multiple partition units (110), and each of the partition units (110) having a sub-texture (11);
an included angle of the sub-texture (11) relative to the row direction (x) being defined as a texture angle (α), and the sub-textures of the multiple partition units (110) satisfying the following requirements:
the texture angles (α) of any two adjacent sub-textures (11) in the first row are different, and the texture angles (α) of the multiple sub-textures (11) in each column form an arithmetic progression along the column direction (y).

15. An electronic device, comprising an appearance decorative member (100) according to any one of claims 1 to 14.
